Europäisches Patentamt

European Patent Office

Office européen des brevets

(19)

(11) Numéro de publication : **0 088 666**
**B1**

(12)

# FASCICULE DE BREVET EUROPÉEN

(45) Date de publication du fascicule du brevet :
01.10.86

(21) Numéro de dépôt : 83400368.3

(22) Date de dépôt : 22.02.83

(51) Int. Cl.⁴ : **H 01 L 39/24**

(54) Microcircuits et procédé de fabrication, notamment pour technologie à effet Josephson.

(30) Priorité : 23.02.82 FR 8202954

(43) Date de publication de la demande :
14.09.83 Bulletin 83/37

(45) Mention de la délivrance du brevet :
01.10.86 Bulletin 86/40

(84) Etats contractants désignés :
DE GB NL

(56) Documents cités :
FR-A- 2 024 592
IBM TECHNICAL DISCLOSURE BULLETIN, vol. 18,
no. 11, avril 1976, pages 3845-3846, New York, USA N.
BRASLAU et al.: "Fabrication of planar Josephson
junctions by laser irradiation"
COMPTES RENDUS, SERIES A&B, SCIENCES
MATHEMATIQUE & PHYSIQUE, vol. 291, no. 5, octobre
1980, pages 145-148, Paris, FR. M. RIBAULT et al.:
"Physique de la matière condensée. - Supraconductivité et absence d'anomalie de Kohn dans le conducteur organique quasi unidimensionnel: (TMTSF)2
AsF6"
Scientific American Vol. 247 No. 1, "Organic Superconductors", par K. BECHGAARD et D. JEROME.

(73) Titulaire : CENTRE NATIONAL DE LA RECHERCHE
SCIENTIFIQUE (CNRS)
15, Quai Anatole France
F-75700 Paris (FR)

(72) Inventeur : Bouffard, Serge Jean Hubert
97/125 Av. R. Salengro
F-92290 Chatenay Malabry (FR)
Inventeur : Zuppiroli, Libéro
5, rue Michal
F-75013 Paris (FR)
Inventeur : Jerome, Denis
1bis, rue des Fonds
F-78350 Jouy en Josas (FR)
Inventeur : Bechgaard, Klaus
H.C. Oersted Institute Universtitetsparken 5
DK-2100 Copenhague (DK)

(74) Mandataire : Pinguet, André et al
NOVAPAT - CABINET CHEREAU 107 Boulevard
Péreire
F-75017 Paris (FR)

Jouve, 18, rue St-Denis, 75001 Paris, France

## Description

La présente invention concerne les techniques de réalisation de microcircuits pour applications en microélectronique, et notamment pour les circuits du type à jonctions Josephson.

Les développements foudroyants des microcomposants électroniques à l'état solide ont abouti, ces dernières années, à la réalisation de circuits ultra-compacts dans la technique dite à grande intégration (Large Scale Integration, L.S.I.) permettant de former quelques milliers de composants actifs, tels que des transistors, sur un même substrat de silicium. Cette technologie se trouve actuellement confrontée, pour passer au stade suivant de la très grande intégration (Very Large Scale Integration — V.L.S.I.), aux problèmes de résolution pour la réalisation des motifs actifs. Malgré les prouesses de la microphotolithographie, la réalisation du masque notamment — au travers duquel s'effectue l'exposition des différentes couches formées sur le substrat semiconducteur — ne permet guère de descendre au-dessous d'une résolution de l'ordre d'une paire de micromètres (malgré des propos théoriques annonçant une résolution de l'ordre du demi-micromètre). La réalisation de tels masques est obtenue par faisceaux d'électrons pilotés par calculateur. Une fois le masque mis en place, la couche sensible est exposée à un rayonnement ou soumise sélectivement à des réactions chimiques. C'est ainsi que des zones d'une couche de silicium peuvent être rendues sélectivement isolantes par oxydation du silicium en silice.

Un procédé de réalisation d'un microcircuit comportant l'irradiation de zones déterminées d'un substrat au moyen d'un faisceau d'électrons de grande énergie afin d'y former des régions conductrices est connu de FR-A-2 024 592.

Le domaine des conducteurs de basse dimensionnalité, et notamment les conducteurs unidimensionnels a fait l'objet depuis quelque temps de recherches poussées, essentiellement de la part des équipes auxquelles appartiennent les inventeurs de la présente demande, notamment pour les propriétés, dans certaines conditions, de supraconduction de ces conducteurs. On peut définir de façon générique, les conducteurs de basse dimensionnalité intéressant la présente invention, comme des matériaux ayant une surface de Fermi ouverte. Les conducteurs quasi unidimensionnels (QID) et leurs alliages possèdent en particulier une surface de Fermi quasi planaire. Il a ainsi été constaté que les conducteurs organiques potentiellement supraconducteurs devenaient isolants sous l'application d'un champ magnétique transverse important, de l'ordre de quelques Tesla. Toutefois, dès la suppression de ce champ magnétique, le conducteur recouvre instantanément son état de conduction électrique.

La présente invention telle qu'elle est caractérisée dans les revendications a pour objet de proposer un procédé de réalisation de microcircuits, et les microcircuits ainsi obtenus, constitués d'un substrat d'un conducteur quasi unidimensionnel (QID) dans lequel sont formés sélectivement des motifs de zones conductrices et isolantes.

Les inventeurs ont en effet constaté que, à la différence de l'application d'un champ magnétique, par irradiation de particules de moyenne ou haute énergie, les conducteurs quasi unidimensionnels devenaient irréversiblement isolants.

Ainsi, selon une caractéristique de l'invention, pour l'obtention d'un microcircuit du type susmentionné, le substrat de conducteur quasi unidimensionnel est irradié suivant des zones déterminées par un faisceau fin de particules d'énergie supérieure ou égale à 1 keV.

Une constatation similaire a été faite pour certains conducteurs quasi unidimensionnels présentant normalement, à basse température des caractéristiques d'isolants et qui, irradiés dans les mêmes conditions, deviennent irréversiblement conducteurs à ces mêmes basses températures.

Dans le premier cas susmentionné, l'irradiation fournit des zones isolantes ayant une structure d'isolant dite désordonnée, les zones non irradiées conservant leurs qualités de conduction, voire de supra-conduction à basse température.

Dans le second cas, le matériau quasi unidimensionnel ayant une structure isolante dite de Peierls ou de Slater voit les zones irradiées devenir irréversiblement conductrices.

Les microcircuits obtenus suivant le procédé de l'invention se révèlent particulièrement intéressants dans des utilisations à basses températures, à partir de la température de l'azote liquide (77 °K), et notamment aux très basses températures pour la réalisation de circuits supra-conducteurs utilisant des jonctions tunnel du type Josephson immédiatement réalisables par pilotage du faisceau de particules lors de la formation des zones conductrices et isolantes.

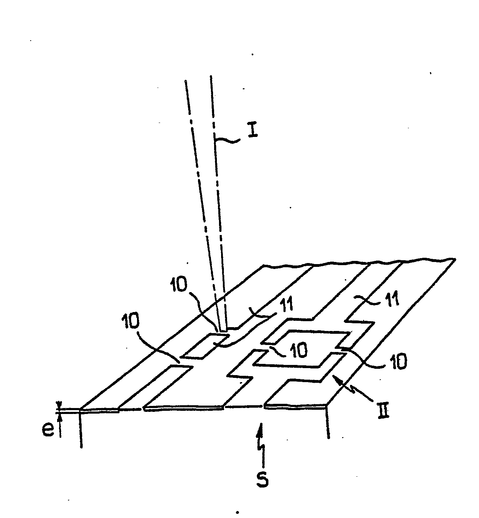

D'autres caractéristiques et avantages de la présente invention ressortiront de la description suivante, faite notamment en relation avec le dessin annexé, sur lequel :

La figure unique représente schématiquement la réalisation de jonctions Josephson directement sur un substrat de conducteur quasi unidimensionnel suivant le procédé de l'invention.

La majeure partie des conducteurs quasi unidimensionnels sont constitués de conducteurs organiques, quoique certains composés non organiques présentent également des caractéristiques similaires, comme on le verra par la suite. De nombreux conducteurs organiques ont été réalisés. On peut ainsi citer les composés TTF-TCNQ, $(TTT)_2I_3$, TMTTF-TCNQ et les molécules correspondantes dans lesquelles le soufre est remplacé par du sélénium. Une classe particulièrement importante de ces produits est constituée par la famille $(TMTSF)_2X$, où TMTSF [$\Delta^{2,2}$-Bi-4,5-diméthyl-1,3-disélénolylidène] est la molécule organique constituant l'élément de base et X est un anion inorganique assurant la

2

formation du sel de cation radiculaire, X étant choisi parmi le groupe comprenant $PF_6^-$, $AsF_6^-$, $SbF_6^-$, $TaF_6^-$, $ReO_4^-$ et $ClO_4^-$ et autres anions monovalents. Les composés de cette dernière famille présentent tous des caractéristiques de supra-conduction à des températures basses, les températures de transition pouvant être augmentées pour les composés réticulés obtenus par le procédé décrit dans la demande de brevet français FR-A-2 510 309 du 22 juillet 1981.

Comme susmentionné, en irradiant ces composés avec un faisceau fin de particules ionisantes (rayon X ou $\gamma$) ou encore d'électrons, avec une énergie supérieure à 1 keV, de préférence supérieure à 8 keV, les zones irradiées prennent de façon irréversible une structure d'isolant désordonné qui se conserve par exemple quand le composé est amené de la température ambiante à la température cryogénique où les zones non irradiées deviennent supraconductrices. On peut obtenir, une résolution sub-micronique, pouvant descendre jusqu'à 10 nm (100 Angstroms) et réaliser ainsi des motifs alternativement conducteurs et isolants sur un substrat cristallin, ou un film polycristallin ou orienté obtenu par exemple par évaporation en surface. On a représenté sur la figure unique un procédé de réalisation de microcircuits où le faisceau de particules I, piloté par ordinateur est en train de former sur la surface du substrat S une zone isolante 10 interrompant un ruban conducteur 11 pour la réalisation d'une jonction tunnel Josephson. Ce procédé permet de réaliser des jonctions Josephson en série, comme représenté sur la partie gauche de la figure. Sur la partie droite de la figure, on a représenté, obtenue de la même façon par balayage d'un faisceau, une structure « SQUID » II (« Superconducting Quantum Interference Device »).

En mettant en œuvre la technique selon l'invention, on peut ainsi réaliser des microcircuits utilisables à des températures cryogéniques pour la mise en œuvre de toutes les techniques utilisant l'effet Josephson, par exemple pour réaliser des détecteurs (par rectification de la non-linéarité quasi particulaire), des amplificateurs (par modulation magnétique du courant critique SQUID), des portes logiques ou des mémoires (en enfermant le flux d'information dans des boucles supraconductrices). On peut également réaliser des générateurs, des transducteurs ou des dispositifs micrométriques à réseaux de jonctions Josephson.

Les études ont démontré que les modifications de structure créées par le faisceau de particules se produisent sur une épaisseur e qui est fonction de l'énergie des particules incidentes. Des électrons de 40 keV à 100 keV produisent une modification uniforme sur des épaisseurs de 10 à 60 $\mu$m respectivement. L'épaisseur de la région délimitant la frontière entre une zone conductrice et une zone isolante est de l'ordre du micron, de sorte qu'il est concevable de fabriquer par irradiation des gravures soit sur toute l'épaisseur de l'échantillon, en utilisant un rayonnement d'énergie initiale suffisante, soit sur une portion de l'épaisseur en limitant l'énergie initiale des particules. Il est ainsi possible d'envisager des techniques de gravure tridimensionnelles et non plus simplement bidimensionnelles.

Dans l'optique d'une technologie utilisant l'effet Josephson, on utilisera de préférence $(TMTSF)_2ClO_4$ qui devient supraconducteur au-dessous de 1,25 °K sous pression atmosphérique. Pour le supraconducteur organique $(TMTSF)_2PF_6$, la température de transition supraconductrice se situe au-dessus de 1 °K sous forte pression. Cependant, les composés de la série $(TMTSF)_2X$ présentent un régime précurseur de l'état supraconducteur dès les températures inférieures à 40 °K. Ces effets précurseurs ont pour effet d'augmenter considérablement la conductivité à basse température. Le tableau ci-dessous donne, pour le composé $(TMTSF)_2PF_6$, les profondeurs de pénétration et les doses critiques $\phi_C$ exprimées en millicoulombs par centimètre carré, pour trois énergies typiques des électrons de bombardement, de façon que la résistivité de la zone irradiée soit à 4 K, au moins 1 000 fois plus forte que la résistivité de l'état métallique de départ à la même température à 4,2 Kp ($\phi_C$, 4,2 K) $\geqslant$ 1 000 $\rho$ (4,2 K). Cette relation reste vraie sur tout le parcours de l'électron.

Tableau

| Energie des élec-trons | $\phi_C$ | Profondeur de pénétration |
|---|---|---|
| 40 keV | 1 mC/cm$^2$ | 200 $\mu$m |
| 100 keV | 2 mC/cm$^2$ | 100 $\mu$m |
| 1 MeV | 4 mC/cm$^2$ | 4 mm |

Comme mentionné plus haut, un comportement similaire se retrouve chez des supraconducteurs quasi unidimensionnels inorganiques tels que $NbSe_3$. Toutefois, dans ce cas, il faut travailler avec des flux de particules de plusieurs centaines de keV pénétrant plusieurs centaines de microns du substrat. Avec $NbSe_3$, par exemple, il faut une dose de 300 mC/cm$^2$ (pour des électrons d'énergie 3 MeV) pour passer d'un état de très faible résistivité de 20 $\mu\Omega \cdot$ cm à un état isolant désordonné de 6,50 $\Omega$cm.

Dans la seconde approche évoquée plus haut, où l'irradiation forme dans un substrat isolant à structure de Peierls des zones conductrices, on peut citer, parmi les composés présentant à basse température ces propriétés isolantes, TMTSF-DMTCNQ [DMTCNQ = 2,5-diméthyl-7,7',8,8'-tétracyano- quino diméthane]. Ce composé a, par exemple, à 4,2 K une résistivité $\rho_{4,2} \simeq 10,4\ \Omega \cdot$ cm. Pour faire passer, à cette même température, certaines parties du composé cristallin de cet état isolant à un état 1 000 fois plus conducteur, il suffit d'une dose de 0,75 mC/cm$^2$ d'électrons de 40 keV ou 3 mC/cm$^2$ d'électrons de 1 MeV.

**Revendications**

1. Microcircuit comprenant un substrat (S) dans lequel est formé un motif de zones conductrices (11) et isolantes (10) alternées, caractérisé en ce que le substrat est un conducteur quasi unidimensionnel.

2. Microcircuit selon la revendication 1, caractérisé en ce que les zones isolantes (10) sont à structure de type isolant désordonné.

3. Microcircuit selon la revendication 1, caractérisé en ce que les zones isolantes (10) sont à structure d'isolant du type de Peierls.

4. Microcircuit selon l'une des revendications 1 à 3, caractérisé en ce qu'il est prévu pour être utilisé à une température inférieure à 77 °K.

5. Microcircuit selon la revendication 3 et la revendication 4, caractérisé en ce que le substrat (S) est TMTSF-DMTCNQ.

6. Microcircuit selon la revendication 2 et la revendication 4, caractérisé en ce que le substrat (S) est (TMTSF)$_2$ClO$_4$.

7. Microcircuit selon la revendication 2 et la revendication 4, caractérisé en ce que le substrat (S) est un composé non organique.

8. Microcircuit selon la revendication 2, caractérisé en ce qu'il est prévu pour être utilisé dans des conditions de température où les zones conductrices (11) sont supraconductrices.

9. Microcircuit selon la revendication 8, caractérisé en ce que le motif des zones conductrices (11) et isolantes (10) forme des jonctions Josephson.

10. Procédé de réalisation d'un microcircuit notamment un microcircuit supraconducteur sur un substrat, dans lequel procédé, les caractéristiques du substrat sont modifiées par irradiation de zones déterminées de ce substrat au moyen d'un faisceau de particules ionisantes caractérisé en ce que l'on prend un substrat constitué par un conducteur quasi unidimensionnel tel que TMTSF-DMTCNQ, (TMTSF)$_2$ClO$_4$, (TMTSF)$_2$PF$_6$ ou NbSe$_3$, sur lequel on forme des zones conductrices et isolantes alternées par irradiation de zones déterminées de ce substrat au moyen d'un faisceau de particules d'énergie supérieure à 1 keV.

11. Procédé selon la revendication 10 pour la réalisation de microcircuits selon la revendication 2, caractérisé en ce que le balayage du faisceau forme les zones isolantes (10).

**Claims**

1. A microcircuit including a substrate (S) wherein an alternating conductive (11) and insulating (10) region pattern is formed, characterized in that said substrate is a quasi-dimensional conductor.

2. The microcircuit as recited in claim 1, characterized in that said insulating regions (10) have a structure of the random insulating type.

3. The microcircuit as recited in claim 1, characterized in that said insulating regions (10) have a structure of the Peierls insulating type.

4. The microcircuit as recited in any claim 1 to 3, characterized in that it is provided to be used at a temperature lower than 77 °K.

5. The microcircuit as recited in claim 3 and in claim 4, characterized in that said substrate (S) includes TMTSF-DMTCNQ.

6. The microcircuit as recited in claim 2 and in claim 4, characterized in that said substrate includes (TMTSF)$_2$ClO$_4$.

7. The microcircuit as recited in claim 2 and in claim 4, characterized in that said substrate (S) includes an inorganic compound.

8. The microcircuit as recited in claim 2, characterized in that it is provided to be used in temperature conditions where said conductive regions (11) are superconducting regions.

9. The microcircuit as recited in claim 8, characterized in that said conductive (11) and insulating (10) region pattern forms Josephson junctions.

10. A process for making a microcircuit, especially a superconducting microcircuit on a substrate, in which process the substrate features are modified by irradiating predetermined regions of said substrate by means of a ionizing particle beam, characterized in that a substrate formed of a quasi-dimensional conductor such as TMTSF-DMTCNQ, (TMTSF)$_2$ClO$_4$, (TMTSF)$_2$PF$_6$ or NbSe$_3$ is provided, on which alternating conductive and insulating regions are formed by irradiating predetermined regions of said substrate by means of a particle beam with an energy higher than 1 keV.

11. The process as recited in claim 10, for making the microcircuits of claim 2, characterized in that the beam scanning forms said insulating regions (10).

**Patentansprüche**

1. Mikroschaltkreis mit einem Substrat S, in dem ein Muster von abwechselnd leitenden Bereichen (11) und isolierenden Bereichen (10) angeordnet ist, dadurch gekennzeichnet, daß das Substrat ein quasi-eindimensionaler Leiter ist.

2. Mikroschaltkreis nach Anspruch 1, dadurch gekennzeichnet, daß die isolierenden Bereiche (10) einen ungeordnet isolierenden Aufbau aufweisen.

3. Mikroschaltkreis nach Anspruch 1, dadurch gekennzeichnet, daß die isolierenden Bereiche (10) einen isolierenden Aufbau vom Typ Peierls aufweisen.

4. Mikroschaltkreis nach einem der Ansprüche 1 bis 3, dadurch gekennzeichnet, daß er dazu vorgesehen ist bei einer Temperatur von weniger als 77 °K verwendet zu werden.

5. Mikroschaltkreis nach Ansprüchen 3 und 4, dadurch gekennzeichnet, daß das Substrat S aus TMTSF-DMTCNQ besteht.

6. Mikroschaltkreis nach Ansprüchen 2 und 3, dadurch gekennzeichnet, daß das Substrat S aus $(TMTSF)_2ClO_4$ besteht.

7. Mikroschaltkreis nach Ansprüchen 2 und 4, dadurch gekennzeichnet, daß das Substrat S aus einer nichtorganischen Verbindung besteht.

8. Mikroschaltkreis nach Anspruch 2, dadurch gekennzeichnet, daß er dazu vorgesehen ist, bei Temperaturbedingungen verwendet zu werden, bei denen die leitenden Bereiche (11) supraleitend sind.

9. Mikroschaltkreis nach Anspruch 8, dadurch gekennzeichnet, daß das Muster der leitenden Bereiche (11) und der isolierenden Bereiche (10) Josephson-Übergänge bildet.

10. Verfahren zur Herstellung eines Mikroschaltkreises insbesondere eines supraleitenden Mikroschaltkreises auf einem Substrat, bei dem die Eigenschaften des Substrats durch Bestrahlung bestimmter Bereiche des Substrates mit einem Bündel aus ionisierenden Teilchen verändert werden, dadurch gekennzeichnet, daß ein Substrat verwendet wird, das aus einem quasi-eindimensionalen Leiter wie z. B. TMTSF-DMTCNQ, $(TMTSF)_2ClO_4$, $(TMTSF)_2PF_6$ oder $NbSe_3$ besteht, auf dem abwechselnd leitende und isolierende Bereiche mittels Bestrahlung vorbestimmter Bereiche des Substrates mittels eines Bündels von Teilchen gebildet werden, deren Energie größer als 1 keV sind.

11. Verfahren nach Anspruch 10, zur Herstellung von Mikroschaltkreisen nach Anspruch 2, dadurch gekennzeichnet, daß durch Bestreichen mit dem Bündel isolierende Bereiche (10) entstehen.